Europäisches Patentamt

European Patent Office

Office européen des brevets

(11) Veröffentlichungsnummer: **0 339 520**
**A2**

## (12) EUROPÄISCHE PATENTANMELDUNG

(21) Anmeldenummer: 89107283.7

(22) Anmeldetag: 22.04.89

(51) Int. Cl.4: **G03F 7/08**

(30) Priorität: 27.04.88 DE 3814178

(43) Veröffentlichungstag der Anmeldung:
02.11.89 Patentblatt 89/44

(84) Benannte Vertragsstaaten:
**BE CH DE ES FR GB IT LI NL SE**

(71) Anmelder: **BASF Aktiengesellschaft**
**Carl-Bosch-Strasse 38**
**D-6700 Ludwigshafen(DE)**

(72) Erfinder: **Nick, Bernhard, Dr.**
**Sinsheimer Strasse 20**
**D-6700 Ludwigshafen(DE)**
Erfinder: **Schulz, Guenther, Dr.**
**Im Roehrich 45**
**D-6702 Bad Duerkheim(DE)**

(54) Lichtempfindliches Aufzeichnungsmaterial.

(57) Die Erfindung betrifft ein lichtempfindliches, negativ arbeitendes Aufzeichnungsmaterial.

Dieses enthält mindestens ein Diazoniumsalz als lichtempfindliche Verbindung, mindestens ein polymeres Bindemittel, das (Meth)acrylanilid einpolymerisiert enthält, und gegebenenfalls andere Hilfs- und Zusatzstoffe.

Das erfindungsgemäße Aufzeichnungsmaterial eignet sich insbesondere zur Herstellung von Flachdruckplatten.

EP 0 339 520 A2

# Lichtempfindliches Aufzeichnungsmaterial

Die Erfindung betrifft ein negativ arbeitendes lichtempfindliches Aufzeichnungsmaterial, das ein Diazoniumsalz, ein Bindemittel sowie übliche Hilfs- und Zusatzstoffe enthält sowie ein Verfahren zur Herstellung von Flachdruckplatten.

Negativ arbeitende, lichtempfindliche Gemische, die ein Diazoniumsalz und ein polymeres Bindemittel enthalten, haben ein breites Anwendungsgebiet speziell als lichtempfindliche Decklacke für Offsetdruckplatten gefunden. Dabei wird die Änderung der Löslichkeit durch Belichtung ausgenutzt. Eine Offsetdruckplatte wird im allgemeinen hergestellt, indem man ein Gemisch aus lichtempfindlichem Material, z.B. Diazoverbindung mit einem Bindemittel und anderen Hilfsstoffen, z.B. Stabilisatoren, Sensibilisatoren und Farbstoffen, auf einem hydrophilen Metall oder Papier, bevorzugt in üblicher Weise vorbehandeltes Aluminium, aufträgt. Durch Belichtung werden die bestrahlten Stellen auf der Druckplatte unlöslich, so daß die nicht belichteten Stellen mit einem Entwickler entfernt werden können. Dadurch werden hydrophile und lipophile Stellen auf der Druckplatte gebildet, so daß mit Wasser und Farbe gedruckt werden kann.

Zur Belichtung können üblicherweise Quecksilberhochdrucklampen, Halogenlampen oder Laser, die im sichtbaren Bereich oder im nahen UV-Licht emittieren, eingesetzt werden.

Für negativ arbeitende, lichtempfindliche Gemische, die ein Diazoniumsalz und ein polymeres Bindemittel gemäß dem Stand der Technik enthalten, werden zur Entwicklung wäßrige Lösungen benötigt, die im pH-Wert auf das jeweils verwendete Bindemittel abgestimmt sind; d.h. daß für jede Druckplatte eine Entwicklerlösung mit eng begrenztem pH-Wert eingesetzt werden muß. Verschiedene Druckplatten sind daher hinsichtlich der Entwicklungslösung untereinander nicht kompatibel. Bei Verwendung von Entwicklungslösungen, die hinsichtlich des pH-Wertes nicht optimal auf die Bindemittel abgestimmt sind, erhält man nach dem Entwickeln Offsetdruckplatten, die entweder in der Reproduktionsqualität oder in den für den Offsetdruck wichtigen hydrophilen Eigenschaften der nichtdruckenden Bildstellen negativ beeinflußt werden.

Aufgabe der vorliegenden Erfindung war es, ein lichtempfindliches Gemisch auf Basis von Diazoniumsalzen für die Herstellung von Aufzeichnungsmaterialien, insbesondere Flachdruckplatten, aufzuzeigen, das mit Entwicklungslösungen verschiedener pH-Werte entwickelt werden kann.

Überraschend wurde gefunden, daß bei Verwendung von Polymeren, die (Meth)acrylanilid einpolymerisiert enthalten, die Entwicklung in einem breiten pH-Bereich durchgeführt werden kann.

Gegenstand der vorliegenden Erfindung ist ein lichtempfindliches, negativ arbeitendes Aufzeichnungsmaterial, das mindestens ein Diazoniumsalz als lichtempfindliche Verbindung, mindestens ein polymeres Bindemittel und gegebenenfalls andere Hilfs- und Zusatzstoffe enthält, das dadurch gekennzeichnet ist, daß das polymere Bindemittel (Meth)acrylanilid einpolymerisiert enthält.

Vorzugsweise enthält das polymere Bindemittel 1 bis 60 Gew.%, bezogen auf Gesamtmenge des polymeren Bindemittels (Meth)acrylanilid einpolymerisiert. Gemäß einer weiteren bevorzugten Ausführungsform der Erfindung enthält das polymere Bindemittel Carboxylgruppen und kann so mit wäßrigen Lösungen entwickelt werden.

Als Diazoniumsalz enthält das Aufzeichnungsmaterial vorzugsweise das Hexafluorophosphat des Polykondensationsproduktes von 4-Diazodiphenylamin mit Formaldehyd.

Gegenstand der vorliegenden Erfindung ist außerdem ein Verfahren zur Herstellung von Flachdruckplatten, wobei man erfindungsgemäßes lichtempfindliches Aufzeichnungsmaterial in gelöster Form auf einen in üblicher Weise vorbehandelten Aluminiumträger aufbringt und das Lösungsmittel in üblicher Weise, beispielsweise durch Verdampfen oder Verdunsten, entfernt.

Bevorzugte Schichtdicken sind hierbei 0.1 bis 50, vorzugsweise 1 bis 5 μm.

Das polymere Bindemittel enthält erfindungsgemäß (Meth)acrylanilid, vorzugsweise Methacrylanilid, und zwar im allgemeinen in Mengen von 1 bis 60, vorzugsweise 5 bis 30 Gew.%, bezogen auf das gesamte polymere Bindemittel, einpolymerisiert.

Als Comonomere kommen die üblichen ethylenisch ungesättigten, polymerisierbaren Verbindungen in Betracht, z.B. Ester der Acrylsäure oder Methacrylsäure mit 1 bis 8, vorzugsweise 1 bis 4 Kohlenstoffatome enthaltenden Alkoholen, z.B. Methyl-, Ethyl-, Propyl-, n-Butyl-, iso-Butyl-, tert.-Butyl-, Hexyl-, Ethylhexyl-acrylat oder -methacrylat; Vinylaromaten, wie z.B. Styrol, Vinyltoluol, hydroxylgruppenhaltige Monomere, wie p-Hydroxystyrol, Allylalkohol, die Monoester der Acryl- oder Methacrylsäure mit mehrwertigen Alkohlen, wie z.B. Propandiol-, Glykol-, Butandiol-, Hexandiol-mono-(meth)acrylat, Acrylnitril, Methacrylnitril, carboxylgruppenhaltige Monomere, wie Acrylsäure, Methacrylsäure, Fumar- oder Maleinsäure, deren Ahydrid und Halbester mit Alkanolen, Itaconsäure, sowie deren Gemische. Bevorzugt sind carboxylgruppenhaltige erfindungsgemäße Copolymerisate, die beispielsweise Säurezahlen zwischen 25 und 120, vorzugsweise 30 und 80 mg KOH/g aufweisen.

Die erfindungsgemäßen polymeren Bindemittel, die auch als Gemische verschiedener Copolymerisate vorliegen können, weisen im allgemeinen K-Werte (nach Fikentscher gemessen 1 %ig in Dimethylformamid) von 20 bis 120, insbesondere 40 bis 80 auf.

Als Diazoniumsalze geeignet sind die üblicherweise verwendeten negativ arbeitenden, lichthärtbaren Diazoverbindungen. Insbesondere geeignet sind Polykondensationsprodukte von Diazoniumsalzen, z.B. von Diphenylamin-4-Diazoniumsalzen, mit Aldehyden.

Das lichtempfindliche Gemisch kann ferner weitere für Offsetdruckplatten übliche bekannte Bestandteile enthalten, wie Farbstoffe, Pigmente, stabilisierende Säuren und Belichtungsindikatoren.

Farbstoffe und Pigmente, die sich als gegebenenfalls mitzuverwendende Hilfs- oder Zusatzstoffe für das Aufzeichnungsmaterial eignen, sind z.B. Acetosol-Grün BLS, Erythrosin, Viktoriareinblau, Methylenblau, Neozappon-Feuerrot oder Pigmente, wie Kupferphthalocyanin.

Als stabilisierende Säuren sind z.B. Phosphor-, Zitronen-, Wein- und Toluolsulfonsäure geeignet.

Geeignete Lösemittel für die Bestandteile des erfindungsgemäßen Gemisches sind z.B. Ethylenglykolether, Alkohole oder niedere Ketone. Im allgemeinen werden die Lösemittel nach dem Auftragen des Gemischs auf einen Aluminiumträger durch Verdampfen entfernt. Der Aluminiumträger kann vorher durch Drahtbürsten, Naßschleifen oder elektrochemisch aufgerauht und anschliessend elektrochemisch mit einer Oxidschicht versehen sein.

Durch Verwendung des erfindungsgemäßen Gemisches ergibt sich gegenüber bekannten negativ arbeitenden lichtempfindlichen Gemischen mindestens ein entscheidender Vorteil, nämlich die Möglichkeit der Entwicklung innerhalb eines breiten pH-Bereiches von etwa 7 bis 12, so daß unterschiedliche Entwickler eingesetzt werden können, ohne daß die Reproduktionsqualität und die hydrophilen Eigenschaften der nicht-druckenden Teile der Druckplatte negativ beeinflußt werden.

Die Erfindung wird anhand der folgenden Beispiele und Vergleichsbeispiele erläutert. Teile sind Gewichtsteile, Prozente oder Mengenverhältnisse sind in Gewichtseinheiten angegeben.

Ein elektrochemisch durch Wechselstrombehandlung in wäßriger HCl-Lösung aufgerauhtes und anodisch in Schwefelsäure oxidiertes Aluminiumblech wird mit wäßriger Silikatlösung (enthält 2 % $Na_2SiO_3$) nachbehandelt.

Die Beschichtungslösung enthält neben dem Bindemittel, das variiert wurde, folgende Komponenten:

7 % Diazoverbindung
1,5 % Viktoriareinblau

Bei der verwendeten Diazoverbindung handelt es sich um das Kondensationsprodukt von p-Diazodiphenyldiazoniumsalz mit Formaldehyd. Die Kondensaton wird in konzentrierter Schwefelsäure durchgeführt. Das lösliche Kondensationsprodukt wird mit Hexafluorphosphat als Gegenion unlöslich und kann aus der Lösung abfiltriert werden. Die Verwendung solcher Diazoniumkondensationsprodukte in negativ arbeitenden Offsetdruckplatten ist bekannt und gebräuchlich.

Das Schichtgewicht betrug 2 $g/m^2$.

Der so beschichtete Träger wird unter einer Quecksilberdampflampe (25 Sekunden Belichtungszeit, 3 kW Leistungsaufnahme, Emissionsspektrum von 290 bis 500 nm, Hauptemission zwischen 350 und 450 nm) durch eine Testvorlage (UGRA-Testkeil) belichtet. In einer kommerziellen Entwicklungsmaschine wurden verschiedene Entwicklerlösungen verwendet:

Lösung 1: Kommerziell erhältliche nylolith® EN-10 (pH 11 bis 11,5)
Lösung 2: Kommerziell erhältliche Kalle EN-143 (pH ca. 8).

Die Entwicklerlösungen wurden nach Herstellervorschrift verdünnt und jeweils frisch angesetzt. In der Entwicklungsmaschine wurden die Probebleche vom Format 4 x 32 cm automatisch mit Entwicklerlösung benetzt. Nach einer Einwirkdauer von 10 bis 20 Sekunden werden die Bleche mit einer rotierenden Bürste abgerieben und mit Leitungswasser nachgespült. Die Geschwindigkeit der Behandlung läßt sich variieren. Gewählt wurde für alle Bleche die gleiche, mittlere Behandlungsgeschwindigkeit.

Bewertet wird das Restschicht-freie Entwickeln und die Resistenz gegen die Entwicklerlösung wie folgt:

Restschichtfreies Entwickeln:

Die Probebleche werden mit Leitungswasser benetzt. Anschließend werden sie mit Offsetfarbe 3 mal leicht und anschließend 3 mal kräftig eingerieben. Wie sich bei der nun folgenden Abspülung der Druckfarbe unter Wasser die Oberfläche der nicht-druckenden Stellen der Druckplatte verhielt, wurde bewertet.

Note 1: Die Farbe perlte sofort von der Oberfläche ab.

Note 2: Nach kurzer Zeit perlte die Druckfarbe von der Oberfläche ab.

Note 3: An einzelnen Stellen war ein Schleier von Druckfarbe trotz Abspülen zu sehen.

Note 4: Die Druckfarbe ließ sich nicht abspülen.

Resistenz gegen Entwickler:

Die Oberfläche der druckenden Teile der Offsetdruckplatte wurde beurteilt:

Note 1: Alle druckenden Teile, auch die feinen Mikrolinien und Rasterfelder sind korrekt wiedergegeben.

Note 2: Die Vollflächen sind intakt, die Wiedergabe der Mikrolinien und Rasterfelder ist nicht perfekt.

Note 3: Die Vollflächen sind angegriffen.

Note 4: Die Vollflächen sind abgelöst.

Die folgenden Angaben in Prozent sind jeweils Gewichtsprozent.

Vergleichsbeispiel 1

Bindemittel = Copolymerisat aus:
15,1 % p-Hydroxyphenylmethacrylanilid
50,6 % Ethylacrylat
13,6 % Acrylnitril
10,7 % Methacrylsäure,
das wie folgt hergestellt wurde:

In einem Vierhalskolben mit Rührer, Innenthermometer, Tropftrichter und Rückflußkühler werden 20 Teile Methanol vorgelegt und auf Siedetemperatur erwärmt. Dazu werden im Verlauf von vier Stunden 8,3 Teile p-Hydroxyphenylmethacrylamid, gelöst in 20 Teilen Methanol, 13,6 Teile Acrylnitril, 60,6 Teile Ethylacrylat, 5,9 Teile Methacrylsäure und 2 Teile Azo-bis-isobutyronitril, gelöst in 5 Teilen Methanol, gegeben und eine weitere Stunde am Rückfluß gehalten. Anschließend werden, verteilt über eine Stunde, 4,5 Teile p-Hydroxyphenylmethacrylamid in 15 Teilen Methanol, 3,2 Teile Methacrylsäure und 0,5 Teile Azo-bis-isobutyronitril in 5 Teilen Methanol zugegeben, und nach einer weiteren Stunde nochmals 2,3 Teile p-Hydroxiphenylmethacrylamid in 15 Teilen Methanol, 1,6 Teile Methacrylsäure und 0,5 Teile Azo-bis-isobutyronitril in 5 Teilen Methanol. Wiederum nach einer Stunde wird 1 Teil Azo-bis-isobutyronitril in 40 Teilen Methanol zugegeben und solange am Rückfluß gehalten, bis die durch Gaschromatographie nachweisbare Restmenge an Acrylnitril weniger als 0,1 %, bezogen auf den nicht flüchtigen Anteil der Lösung, beträgt. Das erhaltene Produkt hat einen K-Wert nach Fikentscher von 49,2 (1 %ig in Dimethylformamid gemessen) und, bezogen auf den nichtflüchtigen Anteil, eine Säurezahl von 50 mg KOH/g.

Entwicklung mit Lösung 1:

Restschichtfreiheit/Farbannahme: Note 1

Entwicklerresistenz/Reproduktionsqualität: Note 3

Entwicklung mit Lösung 2:

Restschichtfreiheit/Farbannahme: Note 2
Entwicklerresistenz/Reproduktionsqualität: Note 2

Vergleichsbeispiel 2

Bindemittel = Copolymerisat aus:
16 % p-Hydroxyphenylmethacrylanilid
64 % Ethylacrylat
13,5 % Acrylnitril
6,5 % Methacrylsäure
, das wie folgt hergestellt wurde:

In einem Vierhalskolben mit Rührer, Innenthermometer, Tropftrichter und Rückflußkühler werden 20 Teile Methanol vorgelegt und auf Siedetemperatur erwärmt. Dazu werden im Verlauf von vier Stunden 8 Teile p-Hydroxiphenylmethacrylamid, gelöst in 18 Teilen Methanol, 13,5 Teile Acrylnitril, 64 Teile Ethylacrylat, 3,9 Teile Methacrylsäure und 0,1 Teil Azobis-iso butyronitril, gelöst in 2 Teilen Methanol, gegeben und sechs Stunden am Rückfluß gehalten. Anschließend werden, verteit über eine Stunde, 4,8 Teile p-Hydroxiphenylmethacrylamid in 13 Teilen Methanol, 1,6 Teile Methacrylsäure und 0,1 Teil Azo-bis-isobutyronitril in 2 Teilen Methanol zugegeben, und nach einer weiteren Stunde nochmals 3,2 Teile p-Hydroxiphenylmethacrylamid in 13 Teilen Methanol, 1 Teil Methacrylsäure und 0,1 Teil Azo-bis-isobutyronitril in 2 Teilen Methanol. Wiederum nach einer Stunde wird 1 Teil Azo-bis-isobutyronitril in 20 Teilen Methanol zugegeben und solange am Rückfluß gehalten, bis die durch Gaschromatographie nachweisbare Restmenge an Acrylnitril weniger als 0,1 %, bezogen auf den nicht flüchtigen Anteil der Lösung, beträgt. Das erhaltene Produkt hat einen K-Wert nach Fikentscher von 57,8 (1 %ig in Dimethylformamid gemessen) und, bezogen auf den nichtflüchtigen Anteil, eine Säurezahl von 36 mg KOH/g.

Entwicklung mit Lösung 1:

Restschichtfreiheit/Farbannahme: Note 2
Entwicklerresistenz/Reproduktionsqualität: Note 1

Entwicklung mit Lösung 2:

Restschichtfreiheit/Farbannahme: Note 4
Entwicklerresistenz/Reproduktionsqualität: Note 1

Beispiel 1

Bindemittel = Copolymerisat aus:

12 % Methacrylanilid
65,4 % Ethylacrylat
13,6 % Acrylnitril
9 % Methacrylsäure,
das wie folgt hergestellt wurde:

In einem Vierhalskolben mit Rührer, Innenthermometer, Tropftrichter und Rückflußkühler werden bei etwa 60°C im Verlauf von vier Stunden 6,6 Teile Methacrylanilid, gelöst in 25 Teilen Methanol, 13,6 Teile Acrylnitril, 65,4 Teile Ethylacrylat, 4,95 Teile Methacrylsäure und 0,2 Teile Azo-bisisobutyronitril, gelöst in 5 Teilen Methanol, gegeben und eine weitere Stunde am Rückfluß gehalten. Anschließend werden, verteilt über eine Stunde, 3,6 Teile Methacrylanilid in 15 Teilen Methanol, 2,7 Teile Methacrylsäure und 0,2 Teile Azo-bis-isobutyronitril in 5 Teilen Methanol zugegeben, und nach einer weiteren Stunde nochmals 1,8 Teile Methacryl anilid in 15 Teilen Methanol, 1,35 Teile Methacrylsäure und 0,2 Teile Azo-bis-isobutyronitril in 5 Teilen Methanol. Nach zwei Stunden werden 2 Teile Azo-bis-isobutyronitril in 40 Teilen Methanol zugegeben und solange am Rückfluß gehalten, bis die durch Gaschromatographie nachweisbare Restmenge an Acrylnitril weniger als 0,1 %, bezogen auf den nichtflüchtigen Anteil der Lösung, beträgt. Das erhaltene Produkt hat einen K-Wert nach Fikentscher von 66 (1 %ig in Dimethylformamid gemessen) und, bezogen auf den nichtflüchtigen Anteil, eine Säurezahl von 61 mg KOH/g.

Entwicklung mit Lösung 1:

Restschichtfreiheit/Farbannahme: Note 1
Entwicklerresistenz/Reproduktionsqualität: Note 1-2

Entwicklung mit Lösung 2:

Restschichtfreiheit/Farbannahme: Note 1
Entwicklerresistenz/Reproduktionsqualität: Note 1

Beispiel 2

Bindemittel = Copolymerisat aus:
18 % Methacrylanilid
59,4 % Ethylacrylat
13,6 % Acrylnitril
9 % Methacrylsäure,
das wie folgt hergestellt wurde:

In einen Vierhalskolben mit Rührer, Innenthermometer, Tropftrichter und Rückflußkühler werden bei etwa 60°C im Verlauf von vier Stunden 9,9 Teile Methacrylanilid, gelöst in 25 Teilen Methanol, 13,6 Teile Acrylnitril, 59,4 Teile Ethylacrylat, 4,95 Teile Methacrylsäure und 0,1 Teil Azo-bis-isobutyronitril, gelöst in 5 Teilen Methanol, gegeben und eine weitere Stunde am Rückfluß gehalten. Anschließend werden, verteilt über eine Stunde, 5,4 Teile Methacrylanilid in 15 Teilen Methanol, 2,7 Teile Methacrylsäure und 0,1 Teil Azo-bis-isobutyronitril in 5 Teilen Methanol zugegeben, und nach einer weiteren Stunde nochmals 2,7 Teile Methacrylanilid in 15 Teilen Methanol, 1,35 Teile Methacrylsäure und 0,1 Teil Azo-bis-isobutyronitril in 5 Teilen Methanol. Nach zwei Stunden werden 2 Teile Azo-bis-isobutyronitril in 40 Teilen Methanol zugegeben und solange am Rückfluß gehalten, bis die durch Gaschromatographie nachweisbare Restmenge an Acrylnitril weniger als 0,1 %, bezogen auf den nichtflüchtigen Anteil der Lösung, beträgt. Das erhaltene Produkt hat einen K-Wert nach Fikentscher von 67 (1 %ig in Dimethylformamid gemessen) und, bezogen auf den nichtflüchtigen Anteil, eine Säurezahl von 65 mg KOH/g.

Entwicklung mit Lösung 1:

Restschichtfreiheit/Farbannahme: Note 1
Entwicklerresistenz/Reproduktionsqualität: Note 2

Entwicklung mit Lösung 2:

Restschichtfreiheit/Farbannahme: Note 1
Entwicklerresistenz/Reproduktionsqualität: Note 1-2

Beispiel 3

Bindemittel = Copolymerisat aus
12 % Methacrylanilid
71,1 % Ethylacrylat
13,6 % Acrylnitril
7,8 % Methacrylsäure,
wie folgt hergestellt:

In einen Vierhalskolben mit Rührer, Innenthermometer, Tropftrichter und Rückflußkühler werden bei etwa 60°C im Verlauf von vier Stunden 15 Teile Methacrylanilid, gelöst in 25 Teilen Methanol, 13,6 Teile Acrylnitril, 63,6 Teile Ethylacrylat, 7,8 Teile Methacrylsäure und 0,1 Teil Azo-bis-isobutyronitril, gelöst in 5 Teilen Methanol, gegeben und eine weitere Stunde am Rückfluß gehalten. Anschließend werden dreimal im Abstand von zwei Stunden je 1 Teil Azo-bis-isobutyronitril in 30 Teilen Methanol zugegeben und solange am Rückfluß gehalten, bis die durch Gaschromatographie nachweisbare Restmenge an Acrylnitril weniger als 0,1 %, bezogen auf den nichtflüchtigen Anteil der Lösung, beträgt. Das erhaltene Produkt hat einen K-Wert nach Fikentscher von 63 (1 %ig in Dimethylformamid gemessen) und, bezogen auf den nichtflüchtigen Anteil, eine Säurezahl von 54 mg KOH/g.

Entwicklung mit Lösung 1:

Restschichtfreiheit/Farbannahme: Note 1-2
Entwicklerresistenz/Reproduktionsqualität: Note 2

Entwicklung mit Lösung 2:

Restschichtfreiheit/Farbannahme: Note 2
Entwicklerresistenz/Reproduktionsqualität: Note 2

Der Druckversuch mit einer Bogen-Offset-Druckmaschine ergab bis 100 000 keinen Schichtabrieb. Auch nach Maschinenstillstand bei 100 000 erfolgt sofortiges Freilaufen der nicht druckenden Bildstellen.

**Ansprüche**

1. Lichtempfindliches, negativ arbeitendes Aufzeichnungsmaterial, das mindestens ein Diazoniumsalz als lichtempfindliche Verbindung, mindestens ein polymeres Bindemittel und gegebenenfalls andere Hilfs- und Zusatzstoffe enthält, dadurch gekennzeichnet, daß das polymere Bindemittel Methacrylanilid oder Acrylanilid einpolymerisiert enthält.

2. Aufzeichnungsmaterial nach Anspruch 1, dadurch gekennzeichnet, daß das polymere Bindemittel 1 bis 60 Gew.%, bezogen auf die Gesamtmenge des polymeren Bindemittels Methacrylanilid oder Acrylanilid einpolymerisiert enthält.

3. Aufzeichnungsmaterial nach einem der vorhergehenden Ansprüche, dadurch gekennzeichnet, daß das polymere Bindemittel Carboxylgruppen enthält.

4. Aufzeichnungsmaterial nach Anspruch 3, dadurch gekennzeichnet, daß es mit wäßrigen Lösungen entwickelbar ist.

5. Aufzeichnungsmaterial nach Anspruch 4, dadurch gekennzeichnet, daß als Diazoniumsalz das Hexafluorophosphat des Polykondensationsproduktes von 4-Diazodiphenylamin mit Formaldehyd eingesetzt wird.

6. Verfahren zur Herstellung von Flachdruckplatten, dadurch gekennzeichnet, daß man lichtempfindliches Aufzeichnungsmaterial gemäß einem der vorhergehenden Ansprüche in gelöster Form auf einen in üblicher Weise vorbehandelten Aluminiumträger aufbringt und das Lösungsmittel entfernt.